# DEMANDE DE BREVET EUROPEEN

(11) **EP 4 492 158 A1**
(43) Date de publication de la demande: **15.01.2025**
(21) Numéro de dépôt: 24187169.8
(22) Date de dépôt: 08.07.2024
(51) Int. Cl.: G04B 19/12, G04B 45/00, C23C 28/00, C23C 16/02, G04B 19/18

(54) **PROCEDE DE DEPOT AMELIORE D'UNE CERAMIQUE**

(30) Priorité: 12.07.2023 CH 748202023
(71) Demandeur: Richemont International S.A., 1752 Villars-sur-Glâne (CH)
(72) Inventeur: EL IDRISSI, Mohamed, 2503 BIENNE (CH); NOIRAUD, Guilhem, 2300 La Chaux-de-Fonds (CH); GAUTIER, Cyrille, 2300 LA CHAUX-DE-FONDS (CH)
(74) Mandataire: LLR

(57) **Abrégé**

L'invention se rapporte à un procédé de fabrication d'un composant horloger avec une couche métallique de décoration revêtue par au moins une couche de protection céramique transparente, le procédé comportant une étape d'immobilisation des groupes hydroxyles sur la couche métallique de décoration afin d'améliorer l'adhérence de la couche de protection céramique transparente sur la couche métallique de décoration.

## Description

### DOMAINE TECHNIQUE DE L'INVENTION

La présente invention se rapporte à un procédé de dépôt d'une céramique telle qu'une couche d'oxyde métallique sur un substrat métallique pour notamment la fabrication d'un cadran d'une pièce d'horlogerie.

### ARRIÈRE-PLAN TECHNIQUE DE L'INVENTION

En horlogerie, des composants d'habillage sont métallisés à des fins esthétiques. En particulier, une grande partie des cadrans produits présente une finition argentée obtenue par le dépôt d'une couche en argent pur par galvanoplastie sur un substrat ou par une pièce en argent massif dans certains cas. Ces cadrans sont ensuite revêtus d'un vernis parfois appelé Zapon. Celui-ci revêt à la fois une fonction esthétique pour donner un effet brillant / mat ainsi qu'une fonction technique pour protéger l'argent pur de l'oxydation.

Dans la pratique, le vernis du type Zapon seul ne suffit pas. En effet, l'argent pur va ternir avec le temps, allant jusqu'à l'oxydation au niveau des arêtes vives (où l'épaisseur de vernis est très faible). Cela entraîne de nombreux retours en service après-vente mais aussi des dégradations des stocks de pièces non montées (exposition à la pollution, à l'humidité, etc.), il y a donc un énorme enjeu financier à protéger de manière durable chaque couche d'argent pur quel que soit l'élément dans lequel elle est montée.

Une finition argentée de haute qualité n'est typiquement obtenue qu'en utilisant une couche en argent pur. En effet, les tentatives de développement d'alliage d'argent moins sensibles au ternissement ont montré que le rendu visuel ne donnait pas satisfaction ou plus généralement était trop éloigné d'une finition argentée haut de gamme. Il est donc important, d'une part, que la couche puisse être déposée par une méthode galvanique pour rester compatible avec les procédés habituels de fabrication des pièces horlogères et, d'autre part, que le dépôt soit en argent pur, c'est-à-dire sans autre métal d'alliage.

Enfin, en horlogerie, il est classique de tester le caractère monobloc des pièces fabriquées (adhérence, résistance mécanique, etc.) afin de garantir sans risques l'assemblage final et la tenue dans le temps de l'ensemble de la pièce d'horlogerie. Tout dépôt sur la couche d'argent doit donc impérativement résister à la délamination notamment lors d'un « test du scotch » qui consiste à tester l'adhérence de la couche externe d'une pièce horlogère par application puis retrait d'une bande collante dont le coefficient adhésif est normalisé afin de garantir une résistance mécanique minimale.

Le document CH 711 122 décrit le dépôt par méthode ALD d'alumine sur une couche métallique. Avant le dépôt par méthode ALD, il est prévu un dégraissage lessiviel qui adsorbe des surfactants sur la couche métallique et aggrave donc le défaut d'adhérence. En effet, un dégraissage lessiviel, selon son pouvoir complexant avec la couche métallique, comprend des tensioactifs qui vont, soit saturer la surface en formant un film inerte à la surface de la couche métallique, soit être incapables d'éliminer les contaminations issues de l'étape de galvanisation.

Pour pallier ce défaut d'adhérence de l'alumine, le document CH 711 122 prévoit, de commencer la méthode ALD par une chauffe puis quelques injections d'eau déionisée (avant les injections habituelles alternées de TMA et d'eau) qui compense partiellement l'effet néfaste du dégraissage lessiviel sur l'adhérence mais ne permet toujours pas d'obtenir une adhérence de l'alumine sur la couche métallique apte à satisfaire au « test du scotch ». Plus précisément, les injections d'eau désionisée présentent par définition un pH neutre à légèrement acide. À ces pH, l'eau peut uniquement s'adsorber à la surface de la couche métallique et générer un film d'eau qui réagit avec les précurseurs ALD mais sans générer de fortes liaisons entre le métal et l'oxyde métallique.

### RÉSUMÉ DE L'INVENTION

L'invention a pour but de proposer un procédé de fabrication d'un composant horloger comportant une couche métallique de décoration revêtue par au moins une couche de protection céramique transparente, le procédé permettant une haute adhérence de la couche de protection céramique transparente sur la couche métallique de décoration étant compatible avec l'utilisation de bains galvaniques horlogers classiques pour le dépôt de la couche métallique de décoration en métal précieux pur et permettant que cette dernière soit protégée durablement de tout ternissement.

À cet effet, l'invention a pour objet un procédé de fabrication d'un composant horloger comportant une couche métallique de décoration revêtue par au moins une couche de protection céramique transparente, **caractérisé en ce que** le procédé comporte les étapes suivantes :
a. former une ébauche du composant horloger dont au moins une partie de la surface externe comporte la couche métallique de décoration ;
b. déposer, par une méthode ALD, ladite au moins une couche de protection céramique transparente sur la couche métallique de décoration afin notamment d'isoler de l'air ambiant la couche métallique de décoration ;
et **en ce que,** entre l'étape a et l'étape b, le procédé comprend l'étape suivante :
c. immobiliser des groupes hydroxyles sur la couche métallique de décoration afin d'améliorer l'adhérence de la couche de protection céramique transparente sur la couche métallique de décoration.

Avantageusement selon l'invention, l'étape a peut former une ébauche au moins partiellement avec la couche métallique de décoration, c'est-à-dire notamment qu'une partie seulement de la surface externe de l'ébauche est revêtue de la couche métallique de décoration ou la totalité de la surface externe de l'ébauche est revêtue de la couche métallique de décoration voire même que la totalité de l'ébauche soit formée de la couche métallique de décoration (pièce massive en un seul matériau). Selon un avantage de l'invention, aucune restriction de matériau de la couche métallique de décoration n'est à prendre en compte aussi bien à cause d'une éventuelle sensibilité à l'oxydation au contact de l'air ambiant qu'à cause de la méthode de dépôt. Le composant obtenu peut donc bénéficier d'une très grande variété de rendus esthétiques et de méthodes de fabrication.

La méthode ALD permet avantageusement selon l'invention de déposer la couche de protection céramique transparente en couche très mince (faible épaisseur à traverser pour garantir une meilleure transparence apte à laisser le plus fidèle possible le rendu esthétique de la couche métallique de décoration par transparence) et uniforme (rendu esthétique homogène sur toute la surface de dépôt et recouvrement homogène pour isoler notamment de l'air ambiant la couche métallique de décoration). Ainsi, la (ou des) couche(s) de protection céramique transparente apporte(nt) une protection optique et mécanique très homogène de manière durable.

À titre d'exemple nullement limitatif, grâce à la couche de protection céramique transparente déposée par le procédé selon l'invention, même dans le cas où la couche métallique de décoration est formée en argent pur, cette dernière sera protégée contre l'oxydation et plus généralement contre toute attaque chimique et physique en gardant son rendu visuel de manière durable, c'est-à-dire notamment ne va pas ternir avec le temps.

En comprenant les réactions mises en jeu dans la méthode ALD, il a été trouvé que l'adhérence de la couche de protection céramique transparente sur la couche métallique de décoration pouvait, avantageusement selon l'invention, être améliorée. En effet, par une immobilisation de groupes hydroxyles liés de façon covalente à la surface métallique de décoration, c'est-à-dire une augmentation sensible tel qu'au moins un doublement (forte densité de groupes hydroxyles), des groupes hydroxyles à la surface de la couche métallique de décoration, il a été obtenu une meilleure adhérence de la couche de protection céramique transparente sur la couche métallique de décoration alors qu'a *priori,* même avec une méthode ALD, l'adhérence entre une couche de métal et une couche de céramique peut être limitée, notamment quand la couche de métal est un métal noble tel que l'argent.

Ainsi, les composants obtenus par le procédé de l'invention n'ont peu voire aucun défaut de qualité à la fabrication suite aux tests de résistance à la délamination notamment celui dit du « test du scotch » classiquement utilisé en horlogerie pour tester le caractère monobloc des pièces fabriquées. Le procédé permet donc avantageusement selon l'invention de pouvoir s'insérer dans les méthodes habituelles de fabrication de pièces horlogères, c'est-à-dire utilise des machines déjà utilisées et parfaitement maîtrisées pour la fabrication de pièces horlogères actuelles.

L'invention peut également comporter l'une ou plusieurs des caractéristiques optionnelles suivantes, prises seules ou en combinaison.

L'étape c peut être obtenue par dégraissage électrolytique à l'aide d'une solution basique afin d'améliorer la durée d'immobilisation des groupes hydroxyles sur la couche métallique de décoration. En effet, l'étape c permet d'oxyder la surface de la couche métallique de décoration tel que l'argent et génère des groupes hydroxyles favorables à l'absorption des précurseurs de la méthode ALD et à la bonne adhérence des oxydes métalliques déposés. Le dégraissage électrolytique est déjà utilisé dans la fabrication de pièces horlogères. Avantageusement selon l'invention, pour l'étape c, le procédé utilise une machine déjà utilisée et parfaitement maîtrisée pour la fabrication de pièces horlogères actuelles. Bien entendu, le dégraissage électrolytique n'est pas la seule méthode possible. Il est également possible de mettre en oeuvre l'étape c par un dégraissage chimique, une adsorption de polymères, une adsorption d'oligomères, une adsorption d'un acide polyacrylique, l'utilisation d'une solution à base d'organosilane et/ou l'utilisation d'une solution à base de surfactants contenant des fonctions hydroxyles.

Actuellement, le dégraissage électrolytique est uniquement utilisé pour préparer les pièces avant une étape de dépôt par galvanoplastie notamment pour maximiser la connexion électrique de la surface externe des pièces et ainsi favoriser la croissance galvanique homogène sur toute la surface externe accessible. De manière différente, l'invention utilise le dégraissage électrolytique à l'aide d'une solution basique, après la formation à l'étape a de l'ébauche tel que par un dépôt par galvanoplastie, pour immobiliser des groupes hydroxyles sur la couche métallique de décoration. De fait, le dégraissage, c'est-à-dire le retrait des molécules lipidiques, n'est pas recherché par l'invention mais uniquement l'immobilisation des groupes hydroxyles sur la couche métallique de décoration en utilisant une machine déjà présente dans l'atelier de fabrication.

En outre, il a été trouvé que le dégraissage électrolytique permet de maintenir des groupes hydroxyles sur la couche métallique de décoration sur une longue durée, c'est-à-dire typiquement autour de vingt-quatre heures. Il est donc très avantageux d'utiliser le dégraissage électrolytique pour mettre oeuvre l'étape c afin d'obtenir une certaine flexibilité de fabrication. Il n'est en effet pas déterminant de réaliser l'étape b immédiatement après l'étape c, c'est-à-dire les étapes a, b et c peuvent être mises en oeuvre séquentiellement sans risque de diminution de la qualité du composant obtenu. À titre d'exemple nullement limitatif, des pièces peuvent être préparées à l'aide de l'étape c du procédé selon l'invention un après-midi et seulement soumises à l'étape b du procédé selon l'invention que le lendemain matin.

La solution basique peut comporter de l'ammoniac et/ou de la soude et/ou de la potasse et/ou du silicate et/ou de l'oxyde métallique et/ou du sol-gel alcalins. À titre d'exemple nullement limitatif, la solution basique peut comporter du métasilicate de disodium et/ou du carbonate de sodium et/ou de l'hydroxyde de sodium. Il est à noter que les silicates peuvent s'adsorber et par conséquent favorise l'accroche.

La couche métallique de décoration peut être obtenue par dépôt physique en phase vapeur, par dépôt chimique en phase vapeur ou par galvanoplastie, par exemple, à base de cuivre, de zinc, de nickel, d'or, d'argent, de platine ou de rhodium. La couche métallique de décoration, et incidemment le composant obtenu, n'a, a *priori,* aucune limite de méthodes de fabrication ce qui permet de bénéficier d'une très grande variété de rendus esthétiques. À titre d'exemple nullement limitatif, la couche métallique de décoration peut comprendre un métal noble, tel que l'argent, l'or, le palladium ou le platine. De préférence, la couche métallique de décoration est à base d'argent.

Ladite au moins une couche de protection céramique transparente est préférentiellement à base d'oxyde. Chaque couche de protection céramique transparente, déposée sous forme cristalline et/ou amorphe, peut notamment comprendre des oxydes notamment métalliques tels que l'oxyde d'aluminium (alumine, Al₂O₃), l'oxyde d'étain (SnO₂), l'oxyde de zinc (ZnO), l'oxyde de titane (TiOz), l'oxyde de silicium (SiOz), l'oxyde de zirconium (zircone, ZrOz), l'oxyde de tantale (Ta₂O₅), l'oxyde de magnésium (MgO), l'oxyde d'indium-étain (parfois abrégé ITO en anglais, combinaison de In₂O₃ et de SnO₂) et l'oxyde d'hafnium (HfO₂). De préférence, la couche de protection céramique transparente est à base d'oxyde d'aluminium (alumine, Al₂O₃).

Le procédé peut comporter, après l'étape b, l'étape finale d : former une couche de vernis sur la surface supérieure du composant horloger obtenu à l'étape b afin d'améliorer son esthétique. Avantageusement selon l'invention, un vernis du type Zapon peut toujours être utilisé pour donner l'aspect esthétique des composants horlogers actuels mais sans risque de ternissement avec le temps (notamment si la couche métallique de décoration est en l'argent pur) grâce au dépôt préalable de la couche de protection céramique transparente.

Le composant horloger peut former une pièce d'habillage tel qu'un cadran ou un réhaut de pièce d'horlogerie.

### BRÈVE DESCRIPTION DES DESSINS

D'autres particularités et avantages de l'invention ressortiront clairement de la description qui en est faite ci-après, à titre indicatif et nullement limitatif, en référence aux dessins annexés, dans lesquels :
- la figure 1 est une vue schématique d'un exemple de pièce d'horlogerie selon l'invention ;
- la figure 2 est une vue en coupe schématique d'un exemple de composant obtenu par le procédé selon l'invention ;
- les figures 3 à 8 sont des vues schématiques d'exemples d'étapes successives du procédé selon l'invention ;
- la figure 9 est un diagramme montrant l'angle de contact de l'ébauche après l'étape a du procédé selon l'invention et l'angle de contact de l'ébauche après l'étape c du procédé selon l'invention ;
- la figure 10 est un diagramme montrant les résultats d'une spectrométrie de photoélectrons induits par rayons X de l'ébauche après l'étape a du procédé selon l'invention et les résultats d'une spectrométrie de photoélectrons induits par rayons X de l'ébauche après l'étape c du procédé selon l'invention ;
- la figure 11 est un diagramme montrant les résultats d'une spectrométrie de photoélectrons induits par rayons X de l'ébauche après l'étape c du procédé selon l'invention en utilisant un bain neuf et les résultats d'une spectrométrie de photoélectrons induits par rayons X de l'ébauche après l'étape c du procédé selon l'invention en utilisant un bain de production déjà utilisé.

### DESCRIPTION DÉTAILLÉE D'AU MOINS UN MODE DE RÉALISATION DE L'INVENTION

Sur les différentes figures, les éléments identiques ou similaires portent les mêmes références, éventuellement additionnés d'un indice. La description de leur structure et de leur fonction n'est donc pas systématiquement reprise.

Dans tout ce qui suit, les orientations sont les orientations des figures. En particulier, les termes « supérieur », « inférieur », « gauche », « droit », « au-dessus », « en-dessous », « vers l'avant » et « vers l'arrière » s'entendent généralement par rapport au sens de représentation des figures. Le terme « horizontal » s'entend donc comme une direction parallèle à la section principale de la platine du mouvement horloger et le terme « vertical » s'entend comme une direction perpendiculaire à la direction horizontale et parallèle à l'épaisseur de la platine du mouvement horloger.

Par « spectre visible humain », on entend le domaine de longueurs d'onde compris entre 380 et 780 nm au sens de la norme ISO/CIE 11664-3:2019 de la Commission internationale de l'éclairage « CIE ».

Par « couche de protection transparente », on entend une couche qui isole physiquement et chimiquement de l'air ambiant tel qu'isolant toute couche inférieure contre laquelle est déposée la couche de protection transparent et qui laisse visible par un oeil humain nu, par transmission au travers de la couche de protection transparente, ladite couche inférieure afin de faire bénéficier de l'esthétique de ladite couche inférieure au composant horloger avec pas ou peu d'altération dans le temps.

Par « méthode ALD », on entend généralement toute méthode de dépôt en couche répondant aux termes anglais « Atomic Layer Déposition ». La méthode ALD est un procédé de dépôt de couches atomiques permettant un dépôt en couche très mince et uniforme, c'est-à-dire typiquement à + / - 1 nm. Ainsi, aussi bien la dimension de l'épaisseur que l'uniformité de l'épaisseur de la (ou des) couche(s) de protection céramique transparente ont été déterminantes pour choisir la méthode ALD dans le cadre de l'invention.

Par « à base de », on entend un matériau ou alliage constituant au moins 50 % en masse totale ou poids d'un élément donné.

Par « métal pur », on entend un matériau formé théoriquement à 100 % en masse totale ou poids d'un métal donné, c'est-à-dire sans autre métal d'alliage. De manière pratique, suivant le procédé de fabrication, le matériau obtenu peut comprendre des éléments dits de pollution dont la proportion en poids ne dépasse pas 0,2 % de la masse totale de l'alliage qui empêche en général d'obtenir les 100 % de métal en masse totale mais plutôt sensiblement entre 97 % et 100 %.

Dans ce qui suit, sauf indication contraire, tous les pourcentages (%) indiqués sont des pourcentages en masse totale ou poids (en anglais « weight »).

Par « pièce d'horlogerie », on entend tous les types d'instruments de mesure ou de comptage du temps tels que les pendules, les pendulettes, les montres, etc...

Par « habillage », on entend tous les types de dispositifs capables de contenir, afficher, décorer et/ou commander un mouvement horloger comme, par exemple, tout ou partie d'une boîte, d'un bracelet ou d'un affichage.

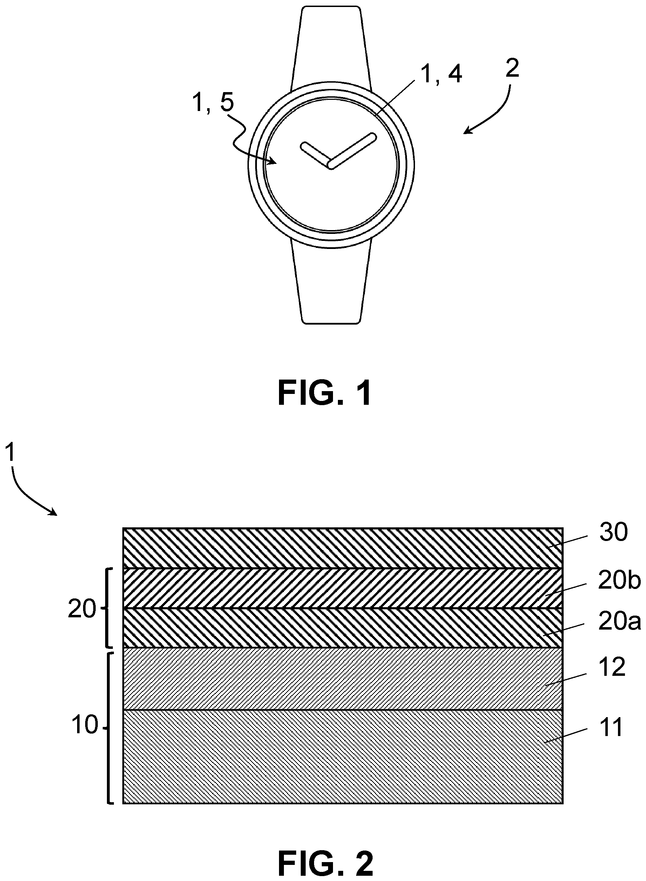

Le composant 1 a été développé pour s'appliquer au domaine horloger. Ainsi, le composant 1 peut former tout ou partie d'un habillage d'une pièce d'horlogerie 2 comme tout ou partie d'un cadran 5 ou d'un réhaut 4 comme illustré à la figure 1, d'un affichage tel qu'une aiguille (deux à la figure 1) ou un disque, d'une boîte, d'un bracelet, d'une glace ou d'un organe de commande tel qu'une couronne ou un bouton-poussoir.

À cet effet, l'invention a pour objet un procédé de fabrication d'un composant 1 horloger comportant une couche 12 métallique de décoration revêtue par au moins une couche 20, 20a, 20b de protection céramique transparente. Le procédé comporte ainsi une première étape a destinée à former une ébauche 10 du composant 1 horloger dont au moins une partie de la surface externe comporte la couche 12 métallique de décoration.

La couche 12 métallique de décoration peut être obtenue par dépôt physique en phase vapeur, par dépôt chimique en phase vapeur ou par galvanoplastie. Elle peut être, par exemple, à base de cuivre (Cu), de zinc (Zn), de nickel (Ni), d'or (Au), d'argent (Ag), de platine (Pt) ou de rhodium (Rh). La couche 12 métallique de décoration, et incidemment le composant 1 obtenu, n'a, a *priori,* aucune limite de méthodes de fabrication ce qui permet de bénéficier d'une très grande variété de rendus esthétiques.

On comprend donc, avantageusement selon l'invention, que l'étape a peut former une ébauche 10 au moins partiellement avec la couche 12 métallique de décoration, c'est-à-dire notamment qu'une partie seulement de la surface externe de l'ébauche est revêtue de la couche 12 métallique de décoration (une première partie 11 de l'ébauche 10 n'est pas revêtue par la couche 12 métallique de décoration) ou la totalité de la surface externe de l'ébauche 10 est revêtue de la couche 12 métallique de décoration (une première partie 11 de l'ébauche 10 est totalement revêtue par la couche 12 métallique de décoration comme illustré à la figure 2) voire même que la totalité de l'ébauche 10 soit formée de la couche métallique de décoration (pièce massive en un seul matériau uniquement formée par la couche 12 métallique de décoration). Selon un avantage de l'invention, aucune restriction de matériau de la couche 12 métallique de décoration n'est à prendre en compte à cause d'une éventuelle sensibilité à l'oxydation au contact de l'air ambiant. Le composant 1 obtenu peut donc bénéficier d'une très grande variété de rendus esthétiques. À titre d'exemple nullement limitatif, la couche 12 métallique de décoration peut comprendre un métal noble, tel que l'argent, l'or, le palladium ou le platine. De préférence, la couche 12 métallique de décoration est à base d'argent.

Suivant le mode de réalisation, on comprend que la première partie 11 est donc optionnelle. Si la première partie 11 est utilisée, elle peut être à base de métal tel que du cuivre ou un laiton.

Le procédé comprend également une étape b destinée à déposer, par une méthode ALD, ladite au moins une couche 20, 20a, 20b de protection céramique transparente sur la couche 12 métallique de décoration afin notamment d'isoler de l'air ambiant la couche 12 métallique de décoration. La méthode ALD permet avantageusement selon l'invention de déposer la couche 20, 20a, 20b de protection céramique transparente en couche très mince (faible épaisseur à traverser pour garantir une meilleure transparence apte à laisser le plus fidèle possible le rendu esthétique de la couche métallique de décoration par transparence) et uniforme (rendu esthétique homogène sur toute la surface de dépôt et recouvrement homogène pour isoler notamment de l'air ambiant la couche métallique de décoration). Ainsi, la (ou des) couche(s) 20, 20a, 20b de protection céramique transparente (deux couches 20, 20a, 20b à la figure 2) apporte(nt) une protection optique et mécanique très homogène de manière durable.

À titre d'exemple nullement limitatif, grâce à la couche 20, 20a, 20b de protection céramique transparente déposée par le procédé selon l'invention, même dans le cas où la couche 12 métallique de décoration est formée en argent pur, cette dernière sera protégée contre l'oxydation et plus généralement contre certaines attaques chimiques et/ou physiques en gardant son rendu visuel de manière durable, c'est-à-dire notamment ne va pas ternir avec le temps.

La couche 20, 20a, 20b de protection céramique transparente est préférentiellement à base d'oxyde. Chaque couche de protection céramique transparente, déposées sous forme cristalline et/ou amorphe, peut notamment comprendre des oxydes notamment métalliques tels que l'oxyde d'aluminium (alumine, Al₂O₃), l'oxyde d'étain (SnO₂), l'oxyde de zinc (ZnO), l'oxyde de titane (TiOz), l'oxyde de silicium (SiOz), l'oxyde de zirconium (zircone, ZrOz), l'oxyde de tantale (Ta₂O₅), l'oxyde de magnésium (MgO), l'oxyde d'indium-étain (parfois abrégé ITO en anglais, combinaison de In₂O₃ et de SnO₂) et l'oxyde d'hafnium (HfO₂).

La méthode ALD consiste à exposer une surface successivement à différents précurseurs chimiques afin d'obtenir des couches ultra-minces de composés métalliques, oxydes ou autres matériaux. Elle est basée sur des réactions de surface auto-saturées qui ont lieu séquentiellement permettant une croissance contrôlée. En général, un cycle d'une méthode ALD comprend au moins deux injections de précurseurs, ces injections étant séparées par une étape de purge servant à éliminer le précurseur et les produits de réaction superflus avant l'introduction de l'autre précurseur. Avantageusement, la technologie ALD permet de déposer des couches sur une surface présentant un très fort rapport d'aspect, car la réaction se déroule sur une monocouche de gaz précurseurs adsorbés directement à la surface.

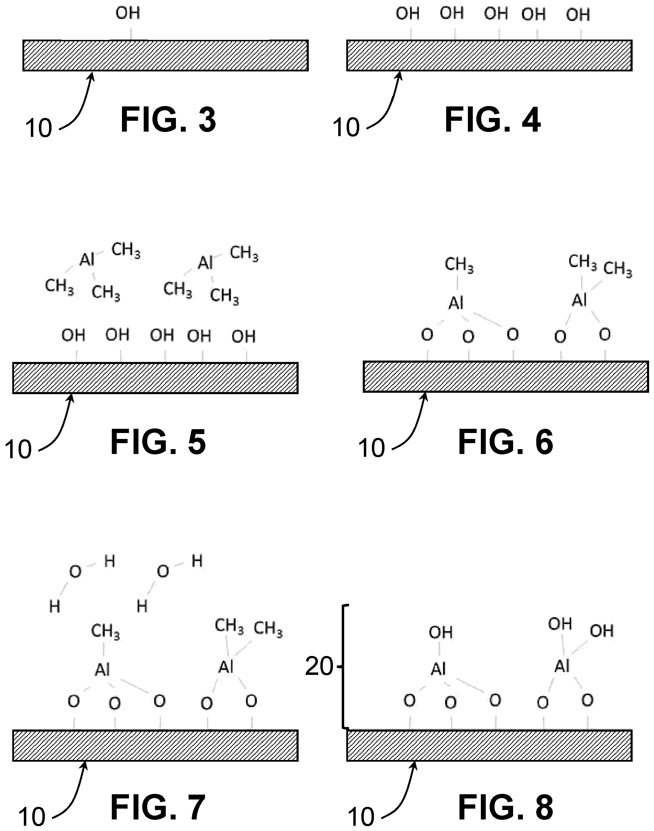

Un exemple de fabrication par méthode ALD est illustré aux figures 5 à 8. Dans un exemple de première phase illustrée à la figure 5, un dosage de l'ébauche 10 est effectué avec un premier précurseur à base de triméthylaluminium (parfois abrégé TMA, (Al₂(CH₃)₆), qui s'adsorbe sur la surface externe de l'ébauche 10 et réagit avec elle. La méthode ALD étant très connue, la première phase ne sera pas davantage expliquée ci-dessous.

Dans un exemple de deuxième phase illustrée à la figure 6, une purge de tous les précurseurs et produits de réactions est effectuée. Puis, dans un exemple de troisième phase illustrée à la figure 7, un dosage est effectué à l'aide d'un deuxième précurseur tel que l'eau (H₂O) qui est une espèce réactive et oxyde la surface en enlevant les ligands de surface. Cette réaction est auto-limitée en raison du nombre limité de ligands de surface. La méthode ALD étant très connue, la troisième phase ne sera pas davantage expliquée ci-dessous. Enfin, dans un exemple de quatrième phase illustrée à la figure 8, une purge des produits de réactions est effectuée. On obtient ainsi la couche 20 de protection céramique transparente à base d'alumine (Al₂O₃) dans l'exemple de la figure 8.

En comprenant les réactions mises en jeu dans la méthode ALD, il a été trouvé que l'adhérence de la couche 20, 20a, 20b de protection céramique transparente sur la couche 12 métallique de décoration pouvait, avantageusement selon l'invention, être améliorée.

Ainsi, avantageusement selon l'invention, entre l'étape a et l'étape b, le procédé comprend l'étape intermédiaire c destinée à immobiliser des groupes hydroxyles (-OH) sur la couche 12 métallique de décoration afin d'améliorer l'adhérence de la couche 20, 20a, 20b de protection céramique transparente sur la couche 12 métallique de décoration.

En effet, nativement, la couche 12 métallique de décoration de l'ébauche 10 peut comprendre un nombre limité de groupes hydroxyles (un seul à la figure 3). L'étape c permet une immobilisation de groupes hydroxyles liés de façon covalente à la surface métallique 12 de décoration, c'est-à-dire une augmentation sensible tel qu'un doublement ou davantage (cinq fois plus à la figure 4), des groupes hydroxyles (-OH) à la surface de la couche 12 métallique de décoration. On comprend immédiatement que le premier précurseur a davantage de sièges de réaction pendant la première phase de la méthode ALD et, qu'au final, il est obtenu une bien meilleure adhérence de la couche 20, 20a, 20b de protection céramique transparente sur la couche 12 métallique de décoration par rapport la couche 12 métallique de décoration native, c'est-à-dire sans étape intermédiaire c selon l'invention.

Ainsi, les composants 1 obtenus par le procédé de l'invention n'ont peu voire aucun défaut de qualité à la fabrication suite aux tests de résistance à la délamination notamment celui dit du « test du scotch » classiquement utilisé en horlogerie de tester le caractère monobloc des pièces fabriquées. Le procédé permet donc avantageusement selon l'invention de pouvoir s'insérer dans les méthodes habituelles de fabrication de pièces horlogères, c'est-à-dire utilise des machines déjà utilisées et parfaitement maîtrisées pour la fabrication de pièces horlogères actuelles.

Selon une variante préférée de l'invention, l'étape c peut être obtenue par dégraissage électrolytique à l'aide d'une solution basique (cf. notamment R. Lévêque, « Traitements et revêtements de surface des métaux », DUNOD, 2013 et J.-J. Duprat, « Dégraissage électrolytique », Techniques de l'ingénieur, 10 octobre 1986). En effet, il a été trouvé que le dégraissage électrolytique permet de maintenir des groupes hydroxyles (-OH) sur la couche 12 métallique de décoration sur une longue durée, c'est-à-dire typiquement autour de vingt-quatre heures. Il est donc très avantageux d'utiliser le dégraissage électrolytique pour mettre en oeuvre l'étape c afin d'obtenir une certaine flexibilité de fabrication. Il n'est ainsi pas obligatoire de réaliser l'étape b dans un temps limité après l'étape c, c'est-à-dire les étapes a, b et c peuvent être mises en oeuvre séquentiellement sans risque de diminution de la qualité du composant 1 obtenu. À titre d'exemple nullement limitatif, des pièces peuvent être préparées à l'aide de l'étape c du procédé selon l'invention un après-midi et seulement soumises à l'étape b du procédé selon l'invention que le lendemain matin. Enfin, si le temps de maintien est dépassé, l'étape c peut être simplement à nouveau réalisée sans perte de qualité pour les composants 1 fabriqués selon le procédé de l'invention.

La solution basique peut comporter de l'ammoniac (NH₄OH) et/ou de la soude (NaOH) et/ou de la potasse (KOH) et/ou du silicate (sel combinant le dioxyde de silicium (SiO₂) à au moins un oxyde métallique) et/ou de l'oxyde métallique (MeₓO_{y}, Me étant un métal) et/ou du sol-gel alcalins (par exemple à base de sodium ou de potassium). À titre d'exemple nullement limitatif, la solution basique peut comporter du métasilicate de disodium (Na₂SiO₃) et/ou du carbonate de sodium (Na₂CO₃) et/ou de l'hydroxyde de sodium (NaOH).

Bien entendu, le dégraissage électrolytique n'est pas la seule méthode possible. Il est également possible de mettre en oeuvre l'étape c par un dégraissage chimique mais il est moins efficace car il ne génère pas ou peu d'anions de la couche 12 métallique de décoration tel que Ag+ à l'anode.

On peut aussi adsorber des polymères et/ou oligomères tels qu'un poly(alcool vinylique) ou un acide polyacrylique qui présente respectivement des fonctions hydroxyle ou carboxylique permettant la condensation des oxydes métalliques et une forte accroche sur les métaux étant donné leur grand nombre de ligands.

Il est également possible d'utiliser des solutions à base d'organosilane (silicium couplé à un groupe alkyle) et/ou de surfactants contenant des fonctions hydroxyles qui s'adsorbent à la surface en couches minces ou en monocouches auto-assemblées (également appelé par l'abréviation anglaise « SAM » venant de l'expression « Self assembled monolayers »).

Ces dernières sont constituées de :
- d'au moins un ligand ayant une forte affinité pour la couche 12 métallique de décoration. Un tel ligand peut par exemple être une fonction thiol dans le cas des alcanes thiols, une fonction acide carboxylique, un méthoxysilane, un éthoxysilane, ou un chlorosilane ;
- un groupe espaceur tel qu'une chaîne alcane ou une chaîne glycol ; et
- un groupe fonctionnel terminal tel qu'un hydroxyle.

On peut par exemple utiliser des thiols tel que le 3-mercapto-1-propanol avec la fonction sulfhydryle servant de ligand, la chaîne propane comme groupe espaceur et le groupe fonctionnel terminal hydroxyle.

Bien entendu, d'autres ligands peuvent être envisagés tels que par exemples les phosphines. La liaison au métal et à l'oxyde peut être améliorée respectivement avec des ligands et des groupes terminaux dipodals ou multipodals présentant plusieurs points d'accroches pour favoriser l'adhérence. Des mélanges de silane et de surfactants peuvent également être utilisés.

Les ligands et groupements fonctionnels terminaux peuvent aussi être protégés pour préserver leur propriété avec par exemple l'utilisation d'un thiocyanate pour protéger une fonction thiol ou d'époxy pour protéger la fonction hydroxyle.

À titre d'exemple nullement limitatif, d'autres ligands peuvent être utilisés tels que le 3-thiolcyanatopropyltriéthoxysilane ou le 3-(diphénylphosphino)éthyltriéthoxysilane. La surface de la couche 12 métallique (tel que l'argent) peut aussi être modifiée notamment avec des fonctions hydroxyles via des traitements plasma ou CVD.

Toutefois, la solution de dégraissage électrolytique est préférée car elle est déjà présentes dans les ateliers horlogers, est facile à mettre en oeuvre et est très efficace.

Selon un exemple, le dégraissage électrolytique (cathodique ou anodique ou les deux de manière alternée et généralement dans deux cuves distinctes) est réalisé à l'aide d'une source de tension extérieure destinée à polariser la pièce à dégraisser positionnée à l'anode ou à la cathode (dégraissage anodique ou cathodique). Des réactions électrochimiques sont induites de ce nouvel état d'équilibre. Dans le cas d'un matériau passif, l'électrolyse va ainsi se résumer à celle de l'eau :
- À la cathode : réduction de l'eau : 2 H₂O + 2 e⁻ → H₂ + 2 OH⁻ (dégagement d'hydrogène)
- À l'anode : oxydation de l'eau : 2 OH⁻→ O₂ + 2 e⁻ + H₂O (dégagement d'oxygène)

Ces dégagements gazeux vont ajouter un effet mécanique au dégraissage. L'oxydation anodique de la couche d'argent permet un léger décapage de la surface d'argent et offre un nettoyage bien plus efficace qu'un nettoyage lessiviel.

Dans l'exemple illustré à la figure 4, le dégraissage électrolytique est utilisé en courant anodique entre 0,5 et 2 A.dm⁻² pendant 0,5 à 5 minutes. L'électrolyte est alcalin avec notamment 10 à 25 % de carbonate de sodium et 2,5 à 10 % d'hydroxyde de sodium. Il peut également contenir 25 à 50 % de métasilicate de disodium.

La formation des groupes hydroxyles peut être attribuée à la réaction entre les sels de métal tel que l'argent générés à l'anode et adsorbés en surface et les bases qui génèrent des oxydes tel que l'oxyde d'argent (AgzO) et l'hydroxyde d'argent (AgOH).

À l'anode : Ag⁰ -> Ag⁺ + 1e⁻

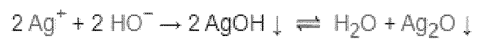

On comprend que les formations d'hydroxydes et d'oxydes d'argent en milieu alcalin forment des liaisons covalentes avec les oxydes métalliques. En outre, la potentielle adsorption de silanol en surface est capable de réagir et de se lier de façon covalente avec les précurseurs ALD.

Dans la variante comportant du métasilicate de disodium, l'adsorption des silicates à la surface de la couche 12 métallique de décoration tel que l'argent peut aussi favoriser la condensation des précurseurs de l'oxyde tel que le triméthylaluminium.

Actuellement, le dégraissage électrolytique est utilisé pour préparer les pièces avant une étape de dépôt par galvanoplastie pour éliminer les résidus de pates à polir, les huiles d'usinage, ainsi que les surfactants présents dans les lessives et émulsions. Le but est notamment de maximiser la connexion électrique de la surface externe des pièces pour favoriser la croissance galvanique homogène sur toute la surface externe accessible. De manière différente, l'invention détourne l'utilisation habituelle du dégraissage électrolytique à l'aide d'une solution basique pour immobiliser des groupes hydroxyles en haute densité sur la couche 12 métallique de décoration favorisant la condensation et l'adhérence de l'oxyde après la formation de l'ébauche (étape a) par exemple par un dépôt par galvanoplastie.

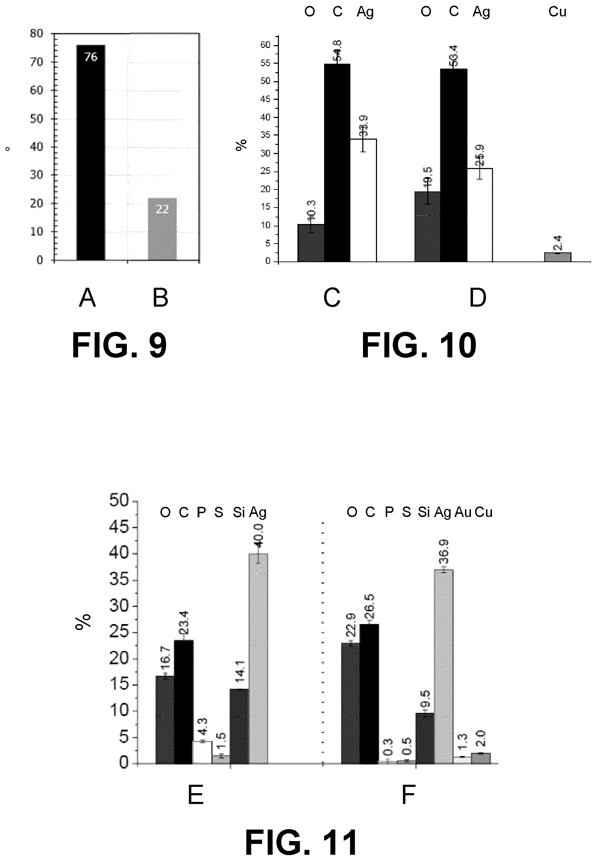

La figure 9 illustre l'angle de contact (en degré) de l'ébauche 10 (référence A) après l'étape a du procédé selon l'invention et l'angle de contact de l'ébauche 10 (référence B) après la variante préférée de l'étape c du procédé selon l'invention montrant que la surface est davantage hydrophile donc avec davantage de liaisons polaires en surface (en comparaison un dégraissage lessiviel ne permet pas d'abaisser l'angle de contact). De fait, le dégraissage, c'est-à-dire le retrait des molécules lipidiques, n'est pas spécialement recherché par l'invention mais surtout l'immobilisation des groupes hydroxyles (-OH) liés de façon covalente à la surface de la couche 12 métallique de décoration en utilisant une machine habituellement déjà présente dans l'atelier de fabrication. Avantageusement selon l'invention, pour la variante préférée de l'étape c, le procédé utilise donc également une machine habituellement déjà utilisée et parfaitement maîtrisée pour la fabrication de pièces horlogères actuelles.

La figure 10 illustre les résultats d'une spectrométrie de photoélectrons induits par rayons X de l'ébauche 10 (référence C) après l'étape a seule du procédé selon l'invention et les résultats d'une spectrométrie de photoélectrons induits par rayons X de l'ébauche 10 (référence D) après la variante préférée de l'étape c du procédé selon l'invention dans laquelle la couche 20 de protection céramique transparente est à base d'alumine et la couche 12 métallique de décoration en argent pur. Après dégraissage, la proportion d'oxygène augmente, passant de 10,3 % à 19,5 % atomique. Dans le même temps, la proportion de carbone reste stable et la proportion d'argent détecté diminue. On peut donc en conclure à une augmentation du nombre de liaisons oxygène en surface (haute densité en groupes hydroxyles), ce qui explique une amélioration de l'adhérence entre l'alumine et l'argent (il est à noter une apparition de cuivre en surface provenant probablement de la pollution du bain).

La figure 11 est un diagramme montrant les résultats d'une spectrométrie de photoélectrons induits par rayons X de l'ébauche 10 (référence E) après la variante préférée de l'étape c du procédé selon l'invention en utilisant un bain neuf et les résultats d'une spectrométrie de photoélectrons induits par rayons X de l'ébauche 10 (référence F) après la variante préférée de l'étape c du procédé selon l'invention en utilisant un bain de production déjà utilisé. Dans les deux cas, la couche 20 de protection céramique transparente est à base d'alumine et la couche 12 métallique de décoration en argent pur. Afin de vérifier l'impact des pollutions tel que le cuivre, les deux lots (références E et F) sont issus de pièces identiques.

Après l'étape b, les deux lots présentent 100 % de tenue au « test au scotch ». La présence de pollutions tel que le cuivre n'est donc pas nécessaire pour obtenir une bonne adhérence, ce qui permet d'affirmer qu'il est possible grâce à l'invention d'avoir une bonne adhérence d'une couche 20, 20a, 20b de protection céramique transparente par une méthode ALD sur une couche 12 métallique de décoration obtenue à partir d'un bain galvanique d'argent sans pollutions de cuivre du bain.

L'invention n'est pas limitée aux modes de réalisation et variantes présentés et d'autres modes de réalisation et variantes apparaîtront clairement à l'homme du métier. Ainsi, les réalisations ci-dessus sont des exemples. Bien que la description se réfère à un ou plusieurs modes de réalisation, ceci ne signifie pas nécessairement que chaque référence concerne le même mode de réalisation, ou que les caractéristiques s'appliquent seulement à un seul mode de réalisation. De simples caractéristiques de différents modes de réalisation peuvent également être combinées et/ou interchangées pour fournir d'autres réalisations.

Par ailleurs, comme illustré à la figure 2, le procédé peut prévoir de conserver le dépôt d'un vernis 30 du type Zapon pour donner l'aspect esthétique des composants horlogers actuels mais sans risque de ternissement avec le temps (notamment si la couche 12 métallique de décoration est en l'argent pur) grâce au dépôt préalable de la couche 20, 20a, 20b de protection céramique transparente. Ainsi, le procédé peut comporter, après l'étape b, l'étape finale d destinée à former une couche de vernis 30 sur la surface supérieure du composant 1 horloger obtenu à l'étape b afin d'améliorer son esthétique.

## Revendications

1. Procédé de fabrication d'un composant (1) horloger comportant une couche (12) métallique de décoration revêtue par au moins une couche (20, 20a, 20b) de protection céramique transparente, **caractérisé en ce que** le procédé comporte les étapes suivantes :
a. former une ébauche (10) du composant (1) horloger dont au moins une partie de la surface externe comporte la couche (12) métallique de décoration ;
b. déposer, par une méthode ALD, ladite au moins une couche (20, 20a, 20b) de protection céramique transparente sur la couche (12) métallique de décoration afin notamment d'isoler de l'air ambiant la couche (12) métallique de décoration ;
et **en ce que,** entre l'étape a et l'étape b, le procédé comprend l'étape suivante :
c. immobiliser des groupes hydroxyles sur la couche (12) métallique de décoration afin d'améliorer l'adhérence de la couche (20, 20a, 20b) de protection céramique transparente sur la couche (12) métallique de décoration.

2. Procédé de fabrication selon la revendication précédente, dans lequel l'étape c est obtenue par dégraissage électrolytique à l'aide d'une solution basique afin d'améliorer la durée d'immobilisation des groupes hydroxyles sur la couche (12) métallique de décoration.

3. Procédé de fabrication selon la revendication précédente, dans lequel la solution basique comporte de l'ammoniac et/ou de la soude et/ou de la potasse et/ou du silicate et/ou de l'oxyde métallique et/ou du sol-gel alcalins.

4. Procédé de fabrication selon la revendication 2 ou 3, dans lequel la solution basique comporte du métasilicate de disodium et/ou du carbonate de sodium et/ou de l'hydroxyde de sodium.

5. Procédé de fabrication selon la revendication 1, dans lequel l'étape c est obtenue par un dégraissage chimique, une adsorption de polymères, une adsorption d'oligomères, une adsorption d'un acide polyacrylique, l'utilisation d'une solution à base d'organosilane et/ou l'utilisation d'une solution à base de surfactants contenant des fonctions hydroxyles.

6. Procédé de fabrication selon l'une quelconque des revendications précédentes, dans lequel la couche (12) métallique de décoration est obtenue par dépôt physique en phase vapeur ou par dépôt chimique en phase vapeur.

7. Procédé de fabrication selon l'une quelconque des revendications 1 à 5, dans lequel la couche (12) métallique de décoration est obtenue par galvanoplastie.

8. Procédé de fabrication selon l'une quelconque des revendications précédentes, dans lequel la couche métallique de décoration est à base de cuivre, de zinc, de nickel ou de rhodium.

9. Procédé de fabrication selon l'une quelconque des revendications 1 à 7, dans lequel la couche métallique de décoration est à base d'or, d'argent, de palladium ou de platine.

10. Procédé de fabrication selon l'une quelconque des revendications précédentes, dans lequel la couche (20, 20a, 20b) de protection céramique transparente est à base d'oxyde.

11. Procédé de fabrication selon la revendication précédente, dans lequel la couche (20, 20a, 20b) de protection céramique transparente est à base d'oxyde d'aluminium.

12. Procédé de fabrication selon l'une quelconque des revendications précédentes, dans lequel, le procédé, après l'étape b, comporte l'étape finale suivante :
d. former une couche (30) de vernis sur la surface supérieure du composant (1) horloger obtenu à l'étape b afin d'améliorer son esthétique.

13. Procédé de fabrication selon l'une quelconque des revendications précédentes, dans lequel le composant (1) horloger forme une pièce (4, 5) d'habillage de pièce d'horlogerie (2).

14. Procédé de fabrication selon la revendication précédente, dans lequel le composant (1) horloger est un cadran (5) ou un réhaut (4) de pièce d'horlogerie (2).
